# EUROPÄISCHE PATENTSCHRIFT

(11) **EP 2 438 004 B1**
(45) Veröffentlichungstag und Bekanntmachung des Hinweises auf die Patenterteilung: **10.06.2015**
(21) Anmeldenummer: 10715167.2
(22) Anmeldetag: 06.04.2010
(51) Int. Cl.: B81B 3/00, H04R 19/00, H04R 19/01

(54) **HALBLEITERBAUELEMENT MIT EINER MIKROMECHANISCHEN MIKROFONSTRUKTUR**
SEMICONDUCTOR COMPONENT HAVING A MICROMECHANICAL MICROPHONE STRUCTURE
COMPOSANT À SEMICONDUCTEUR À STRUCTURE DE MICROPHONE MICROMÉCANIQUE

(30) Priorität: 03.06.2009 DE 102009026677
(43) Veröffentlichungstag der Anmeldung: 11.04.2012
(73) Patentinhaber: Robert Bosch GmbH, 70442 Stuttgart (DE)
(72) Erfinder: REICHENBACH, Frank, 72827 Wannweil (DE); BUCK, Thomas, 71732 Tamm (DE); HOECHST, Arnim, 72770 Reutlingen (DE)
(86) Internationale Anmeldenummer: PCT/EP2010/054519
(87) Internationale Veröffentlichungsnummer: WO 2010/139496

(56) Entgegenhaltungen:
- WO-A2-2007/107736
- BRANDON PILLANS ET AL: "Schottky barrier contact-based RF MEMS switch", MICRO ELECTRO MECHANICAL SYSTEMS, 2007. MEMS. IEEE 20TH INTERNATIONAL CONFERENCE ON, IEEE, PI, 1. Januar 2007 (2007-01-01), Seiten 167-170, XP031203797, ISBN: 978-1-4244-0950-1

## Beschreibung

### Stand der Technik

Die Erfindung betrifft ein Halbleiterbauelement mit einer mikromechanischen Mikrofonstruktur. Diese umfasst mindestens eine akustisch aktive Membran, die als auslenkbare Elektrode eines Mikrofonkondensators fungiert, ein feststehendes akustisch durchlässiges Gegenelement, das als Gegenelektrode des Mikrofonkondensators fungiert, und Mittel zum Anlegen einer Ladespannung zwischen der auslenkbaren Elektrode und der Gegenelektrode des Mikrofonkondensators.

Kapazitive MEMS(Micro-Electro-Mechanical-System)-Mikrofone gewinnen in den unterschiedlichsten Anwendungsbereichen zunehmend an Bedeutung. Dies ist im Wesentlichen auf die miniaturisierte Bauform derartiger Bauelemente und die Möglichkeit zur Integration weiterer Funktionalitäten bei sehr geringen Herstellungskosten zurückzuführen. Besonders vorteilhaft ist die Integration von Signalverarbeitungskomponenten, wie Filtern und Komponenten zur Rauschunterdrückung sowie Komponenten zum Erzeugen eines digitalen Mikrofonsignals. Ein weiterer Vorteil von MEMS-Mikrofonen ist deren hohe Temperaturstabilität.

Die Membran der Mikrofonstruktur wird durch den Schalldruck ausgelenkt. Dadurch ändert sich der Abstand zwischen der Membran und dem feststehenden Gegenelement, was zu einer Kapazitätsänderung des Mikrofonkondensators führt. Diese sehr kleinen Kapazitätsänderungen in der Größenordnung von aF müssen in ein verwertbares elektrisches Signal umgewandelt werden. Dabei hängt die Größe des Messsignals wesentlich von der Höhe der Ladespannung des Mikrofonkondensators ab. Eine hohe Ladespannung hat allerdings auch starke anziehende Kräfte zwischen der beweglichen Membran und der starren Gegenelektrode zur Folge, die ein elektrostatisches Anhaften der Membran an der Gegenelektrode begünstigen. Im Falle von nicht isolierten Elektroden führt die Berührung von Membran und Gegenelektrode zu einem Kurzschluss des Mikrofonkondensators, bei dem es sogar zu einem Verschweißen von Membran und Gegenelektrode kommen kann. Aber auch wenn die Elektroden mit einer dielektrischen Isolationsschicht versehen sind, ist eine großflächige Berührung zu vermeiden, da die zwischen den Elektroden wirkende Anziehungskraft und damit auch die Kraft, die erforderlich ist, um die Elektroden wieder voneinander zu lösen, mit der Größe der Berührungsfläche zunimmt.

Aus der Praxis sind verschiedene Maßnahmen bekannt, um ein Anhaften der Membran an der Gegenelektrode zu vermeiden. Eine Möglichkeit besteht darin, die Membranaufhängung besonders steif auszubilden und/oder den Abstand zwischen Membran und Gegenelektrode zu erhöhen, wodurch bereits eine Berührung der beiden Elektroden verhindert werden soll. Beide Maßnahmen wirken sich nachteilig auf die Empfindlichkeit des Mikrofons aus.

Des Weiteren ist es bekannt, auf der Membran und/oder auf dem Gegenelement kleinflächige Anschläge aus einem isolierenden Material auszubilden, so dass die zum Lösen erforderliche Kraft relativ klein ist. Diese Schutzmaßnahme ist allerdings mit einem erhöhten Herstellungsaufwand verbunden.

Ein Beispiel einer MEMS-Mikrofon strukture ist aus der WO 2007/107736 A2 bekannt.

### Offenbarung der Erfindung

Mit der vorliegenden Erfindung wird eine einfache und kostengünstige Realisierungsform für ein Halbleiterbauelement der eingangs genannten Art vorgeschlagen, dessen Funktionsfähigkeit auch durch Überlastsituationen, bei denen es zu einer Berührung zwischen Membran und Gegenelektrode kommt, nicht beeinträchtigt wird.

Erfindungsgemäß wird dies dadurch erreicht, dass die auslenkbare Elektrode und die Gegenelektrode des Mikrofonkondensators zumindest bereichsweise entgegengesetzt dotiert sind, so dass sie im Berührungsfall eine Diode bilden. Außerdem ist die Ladespannung zwischen der auslenkbaren Elektrode und der Gegenelektrode so gepolt, dass diese Diode in Sperrrichtung geschaltet ist.

Auch ohne dielektrische Beschichtung der Elektroden wird dadurch ein Kurzschluss des Mikrofonkondensators in Überlastsituationen vermieden. Die Kondensatorstruktur wird nicht beschädigt; insbesondere kommt es nicht zu einer Verschweißung der beiden Elektroden, da auch bei einer Berührung von Membran und Gegenelektrode kein Strom über den Mikrofonkondensator fließen kann. Dies trägt zu einer erhöhten Lebensdauer-Stabilität des erfindungsgemäßen Bauelements bei.

Die erfindungsgemäßen Maßnahmen erweisen sich zudem als vorteilhaft, weil die Ladungsverhältnisse, die sich im Berührungsfall zwischen den beiden Elektroden des Mikrofonkondensators ausbilden, einem dauerhaften Anhaften der auslenkbaren Membran an der feststehenden Gegenelektrode entgegenwirken.

Die Dotierung der beiden Elektroden des Mikrofonkondensators kann einfacherweise so ausgelegt werden, dass sich der Dioden-pn-Übergang an der Grenzfläche zwischen den beiden Elektroden befindet. Alternativ dazu kann der Diodenpn-Übergang aber auch innerhalb einer der beiden Elektroden realisiert werden.

In einer vorteilhaften Weiterbildung des erfindungsgemäßen Halbleiterbauelements sind an der beweglichen Elektrode und/oder an der Gegenelektrode Anschlagnoppen ausgebildet. Mit Hilfe solcher Anschlagnoppen lässt sich zum einen die Membranauslenkung in Überlastsituationen begrenzen. Zum anderen erleichtern sie im Berührungsfall ein Ablösen der beweglichen Membran von der Gegenelektrode.

Derartige Anschlagnoppen erweisen sich aber auch bei der Realisierung der erfindungsgemäßen Dotierung als vorteilhaft, da sie die Berührungsstellen zwischen den beiden Elektroden des Mikrofonkondensators definieren und damit die zu dotierenden Bereiche dieser Elektroden. Wie bereits erwähnt, können diese Bereiche entweder so dotiert werden, dass sich der pn-Übergang der im Berührungsfall entstehenden Diode an der Grenzfläche zwischen den Elektroden des Mikrofonkondensators befindet oder innerhalb einer der beiden Elektroden des Mikrofonkondensators.

Bei gleichartig dotierten Elektroden lässt sich ein Dioden-pn-Übergang an der Grenzfläche zwischen den Elektroden einfach durch Umdotieren der Anschlussnoppen oder durch Umdotieren der den Anschlussnoppen gegenüberliegenden Elektrodenbereiche realisieren.

Wenn die beiden Elektroden des Mikrofonkondensators eine entgegengesetzte Grunddotierung aufweisen, lässt sich der Dioden-pn-Übergang einfach innerhalb einer der beiden Elektroden realisieren, indem wieder entweder die Anschlussnoppen oder die den Anschlussnoppen gegenüberliegenden Elektrodenbereiche umdotiert werden, so dass sie die gleiche Dotierung aufweisen wie die gegenüberliegende Elektrode.

### Kurze Beschreibung der Zeichnungen

Wie bereits voranstehend erörtert, gibt es verschiedene Möglichkeiten, die Lehre der vorliegenden Erfindung in vorteilhafter Weise auszugestalten und weiterzubilden. Dazu wird einerseits auf die dem unabhängigen Patentanspruch 1 nachgeordneten Patentansprüche verwiesen und andererseits auf die nachfolgende Beschreibung mehrerer Ausführungsbeispiele der Erfindung anhand der Figuren.
- Fig. 1: zeigt eine schematische Schnittdarstellung eines erfindungsgemäßen Halbleiterbauelements und
- Fig. 2 bis 4: zeigen jeweils eine schematische Schnittdarstellung durch einen Mikrofonkondensator in einer Überlastsituation zur Veranschaulichung die Wirkungsweise unterschiedlicher Dotierungsvarianten.

### Ausführungsformen der Erfindung

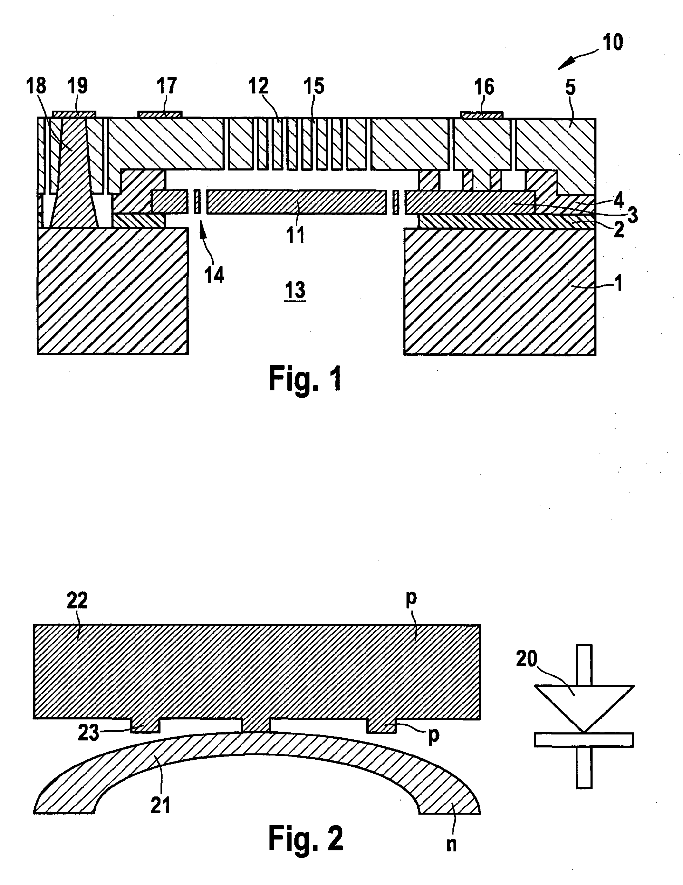

Das in Fig. 1 dargestellte Halbleiterbauelement 10 umfasst eine mikromechanische Mikrofonstruktur mit einer auslenkbaren akustisch aktiven Membran 11 und einem feststehenden akustisch durchlässigen Gegenelement 12, das auch als Backplate bezeichnet wird. Die Membran 11 und das Gegenelement 12 sind hier in einem Schichtaufbau auf einem Halbleitersubstrat 1 realisiert. In der Rückseite des Halbleitersubstrats 1 ist eine Schallöffnung 13 ausgebildet, die sich über die gesamte Dicke des Halbleitersubstrats 1 erstreckt und von der auf der Oberseite des Halbleitersubstrats 1 angeordneten Membran 11 überspannt wird. Die Membran 11 ist in einer dünnen Polysilizium-Schicht 3 realisiert und durch eine erste Isolationsschicht 2 gegen das Halbleitersubstrat 1 elektrisch isoliert. Die Auslenkbarkeit der dünnen Membran 11 wird durch ihre in der Polysiliziumschicht 3 ausgebildete Federaufhängung 14 begünstigt. Im Unterschied dazu ist das Gegenelement 12 in einer relativ dicken Epi-Polysilizium-Schicht 5 über der Membran 11 ausgebildet und fest mit dem Schichtaufbau verbunden. Es ist über eine zweite Isolationsschicht 4 sowohl gegen die Membran 11 als auch gegen das Halbleitersubstrat 1 elektrisch isoliert. Die Dicke dieser zweiten Isolationsschicht 4 bestimmt außerdem den Abstand zwischen Membran 11 und Gegenelement 12 im Ruhezustand. Im Mittelbereich des Gegenelements 12 sind Durchgangsöffnungen 15 ausgebildet, so dass das Gegenelement 12 akustisch durchlässig ist und die schallbedingten Auslenkungen der Membran 11 nicht beeinträchtigt.

Die Membran 11 und das Gegenelement 12 bilden die Elektroden eines Mikrofonkondensators, dessen Kapazität sich mit dem Abstand zwischen Membran 11 und Gegenelement 12 ändert. Zum Erfassen der Kapazitätsänderungen des Mikrofonkondensators wird eine Ladespannung zwischen der Membran 11 und der Gegenelektrode 12 angelegt, die auch als Bias-Spannung bezeichnet wird.

Die Kontaktierung der Elektroden 11, 12 und des Halbleitersubstrats 1 erfolgt über die Bauteiloberseite. Die Kontaktierung der Membran 11 ist in Form eines Anschlusspads 16 auf einem elektrisch isolierten Bereich der Epitaxieschicht 5 realisiert, der direkt auf der Polysilizium-Schicht 3 aufsitzt und so elektrisch mit der Membran 11 verbunden ist. Für die Kontaktierung des Gegenelements 12 ist lediglich ein Anschlusspad 17 auf der Epitaxieschicht 5 erforderlich. In einem weiteren elektrisch isolierten Bereich der Epitaxieschicht 5 wurde eine Durchkontaktierung 18 zum Halbleitersubstrat 1 mit einem oberflächlichen Anschlusspad 19 erzeugt.

Erfindungsgemäß sind die Membran 11 als auslenkbare Elektrode und die Backplate 12 als Gegenelektrode des Mikrofonkondensators entgegengesetzt dotiert. So kann die Membran 11 beispielsweise durch Bor-Belegung p- oder p⁺-dotiert sein, während die Backplate 12 n- oder n⁺-dotiert ist. Ebenso kann aber auch die bewegliche Elektrode 11 n- oder n⁺-dotiert sein und die Gegenelektrode 12 p- oder p⁺-dotiert sein. Da weder die Membran 11 noch die Backplate 12 mit einer Isolationsschicht versehen sind, bilden diese beiden Elektroden 11 und 12 im Berührungsfall eine Diode. Erfindungsgemäß wird die Polung der Bias-Spannung so gewählt, dass diese Diode in Sperrrichtung geschaltet ist. Dadurch wird ein Kurzschluss des Mikrofonkondensators verhindert. Da zwischen der Membran 11 und der Gegenelektrode 12 kein Strom fließt, wird die Mikrofonstruktur auch nicht durch Verschweißen ihrer Komponenten zerstört.

In den Figuren 2 bis 4 sind jeweils lediglich die Membran 21, 31 bzw. 41 und das Gegenelement 22, 32 bzw. 42 eines erfindungsgemäßen Halbleiterbauelements in einer Überlastsituation dargestellt. An der Unterseite des Gegenelements 22, 32 bzw. 42 sind hier Anschlagnoppen 23, 33 bzw. 43 ausgebildet, die genauso wie das Gegenelement 22, 32 bzw. 42 in einem Epitaxieprozess erzeugt worden sind und aus Epi-Polysilizium bestehen.

Im Fall der **Fig. 2** ist das Gegenelement 22 mit den Anschlagnoppen 23 p-dotiert, während die Membran 21 n-dotiert ist. Die Membran 21 ist hier so weit verwölbt, dass sie die mittlere Anschlagnoppe 23 des Gegenelements 22 berührt. In diesem Berührungsbereich bilden die beiden Elektroden 21 und 22/23 des Mikrofonkondensators aufgrund ihrer entgegengesetzten Dotierung eine Diode. Diese Diode ist aufgrund der erfindungsgemäßen Polung der Ladespannung des Mikrofonkondensators in Sperrrichtung geschaltet, was durch das Schaltzeichen 20 in der rechten Bildhälfte symbolisiert wird.

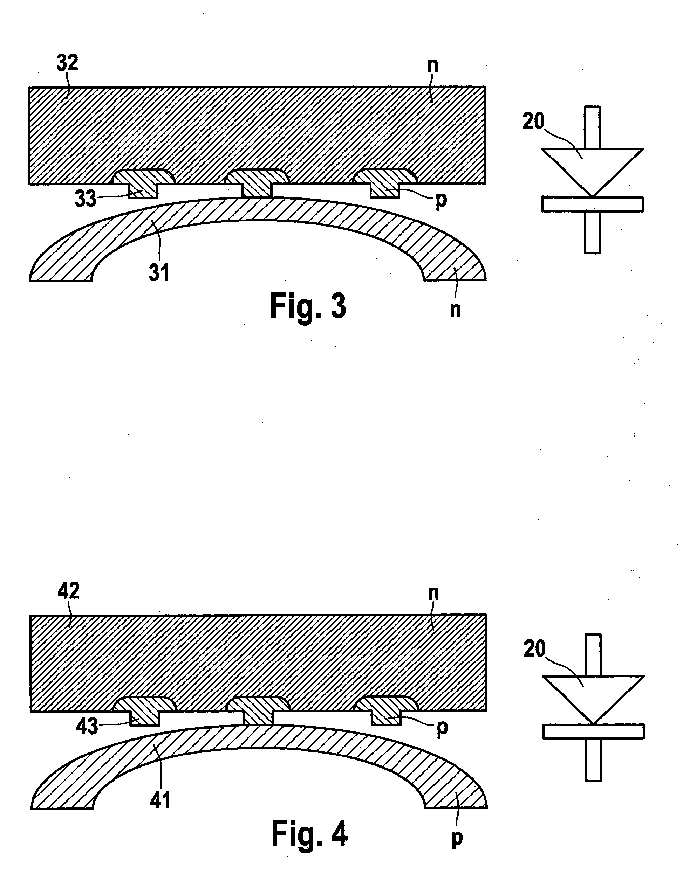

Im Unterschied dazu sind das Gegenelement 32 und die Membran 31 im Fall der **Fig. 3** gleichartig dotiert. Beide Elektroden 31, 32 wurden hier nämlich mit einer n-Dotierung als Grunddotierung versehen. Lediglich die Anschlagnoppen 33 sowie ein angrenzender wannenförmiger Elektrodenbereich sind p-dotiert. Diese p-Dotierung kann beispielsweise in einem gezielten Implantationsprozess erzeugt werden. Auch hier bildet die n-dotierte Membran 31 zusammen mit der mittleren p-dotierten Anschlagnoppe 33 eine in Sperrrichtung geschaltete Diode, deren pn-Übergang sich an der Grenzfläche zwischen Membran 31 und Anschlagnoppe 33 befindet.

Wie im Fall der Fig. 2 weisen das Gegenelement 42 und die Membran 41 bei der in **Fig. 4** dargestellten Dotierungsvariante entgegengesetzte Grunddotierungen auf. So ist das Gegenelement 42 n-dotiert, während die Membran 41 p-dotiert ist. Allerdings wurden auch hier die Anschlagnoppen 43 sowie ein angrenzender wannenförmiger Elektrodenbereich umdotiert, so dass die Anschlagnoppen 43 genauso wie die gegenüberliegende Membran 41 p-dotiert sind. Auch in diesem Fall entsteht durch die Berührung zwischen mittlerer Anschlagnoppe 43 und Membran 41 eine in Sperrrichtung geschaltete Diode. Der pn-Übergang dieser Diode befindet sich - im Unterschied zu den beiden voranstehend beschriebenen Dotierungsvarianten - allerdings innerhalb des Gegenelements 42, und zwar zwischen dem n-dotierten Bereich des Gegenelements 42 und dem p-dotierten, an die mittlere Anschlagnoppe 43 angrenzenden Bereich.

## Patentansprüche

1. Halbleiterbauelement (10) mit einer mikromechanischen Mikrofonstruktur, mindestens umfassend
- eine akustisch aktive Membran (11), die als auslenkbare Elektrode eines Mikrofonkondensators fungiert,
- ein feststehendes akustisch durchlässiges Gegenelement (12), das als Gegenelektrode des Mikrofonkondensators fungiert, und
- Mittel zum Anlegen einer Ladespannung zwischen der auslenkbaren Elektrode (11) und der Gegenelektrode (12) des Mikrofonkondensators;
**dadurch gekennzeichnet, dass** die auslenkbare Elektrode (11) und die Gegenelektrode (12) des Mikrofonkondensators zumindest bereichsweise entgegengesetzt dotiert sind, so dass sie im Berührungsfall eine Diode bilden, und dass die Ladespannung zwischen der auslenkbaren Elektrode (11) und der Gegenelektrode (12) so gepolt ist, dass diese Diode in Sperrrichtung geschaltet ist.

2. Halbleiterbauelement (10) nach Anspruch 1, **dadurch gekennzeichnet, dass** sich der pn-Übergang der Diode an der Grenzfläche zwischen den beiden Elektroden (11, 12) des Mikrofonkondensators befindet.

3. Halbleiterbauelement nach Anspruch 1, **dadurch gekennzeichnet, dass** sich der pn-Übergang der Diode innerhalb einer der beiden Elektroden (42) des Mikrofonkondensators befindet.

4. Halbleiterbauelement nach einem der Ansprüche 1 bis 3, **dadurch gekennzeichnet, dass** an der beweglichen Elektrode und/oder an der Gegenelektrode (22) Anschlagnoppen (23) ausgebildet sind.

5. Halbleiterbauelement nach Anspruch 4, **dadurch gekennzeichnet, dass** die beiden Elektroden (31, 32) des Mikrofonkondensators eine gleichartige Grunddotierung aufweisen und dass die Anschlagnoppen (33) oder die den Anschlagnoppen gegenüberliegenden Elektrodenbereiche entgegengesetzt dotiert sind.

6. Halbleiterbauelement nach Anspruch 4, **dadurch gekennzeichnet, dass** die beiden Elektroden (41, 42) des Mikrofonkondensators eine entgegengesetzte Grunddotierung aufweisen und dass die Anschlagnoppen (43) oder die den Anschlagnoppen gegenüberliegenden Elektrodenbereiche umdotiert sind, so dass sie die gleiche Dotierung wie die gegenüberliegende Elektrode (41) aufweisen.

## Claims

1. Semiconductor component (10) having a micromechanical microphone structure, at least comprising
- an acoustically active membrane (11), which functions as a deflectable electrode of a microphone capacitor,
- a stationary acoustically permeable counterelement (12), which functions as a counter-electrode of the microphone capacitor, and
- means for applying a charging voltage between the deflectable electrode (11) and the counter-electrode (12) of the microphone capacitor;
**characterized in that** the deflectable electrode (11) and the counter-electrode (12) of the microphone capacitor are oppositely doped at least regionally, such that they form a diode in the case of contact, and **in that** the charging voltage between the deflectable electrode (11) and the counter-electrode (12) is polarized such that said diode is reverse-biased.

2. Semiconductor component (10) according to Claim 1, **characterized in that** the pn junction of the diode is situated at the interface between the two electrodes (11, 12).

3. Semiconductor component according to Claim 1, **characterized in that** the pn junction of the diode is situated within one of the two electrodes (42) of the microphone capacitor.

4. Semiconductor component according to any of Claims 1 to 3, **characterized in that** stop lugs (23) are formed on the movable electrode and/or the counter-electrode (22).

5. Semiconductor component according to Claim 4, **characterized in that** the two electrodes (31, 32) of the microphone capacitor have a basic doping of the same type, and **in that** the stop lugs (33) or the electrode regions opposite the stop lugs are oppositely doped.

6. Semiconductor component according to Claim 4, **characterized in that** the two electrodes (41, 42) of the microphone capacitor have an opposite basic doping, and **in that** the stop lugs (43) or the electrode regions opposite the stop lugs are redoped, such that they have the same doping as the opposite electrode (41).

## Revendications

1. Elément semiconducteur (10) présentant une structure micromécanique de microphone et comprenant au moins :
une membrane (11) active acoustiquement fonctionnant comme électrode déformable d'un condensateur de microphone,
un élément complémentaire fixe (12) perméable acoustiquement et fonctionnant comme électrode complémentaire du condensateur de microphone et
des moyens permettant d'appliquer une tension de charge entre l'électrode déformable (11) et l'électrode complémentaire (12) du condensateur de microphone, **caractérisé en ce que**
l'électrode déformable (11) et l'électrode complémentaire (12) du condensateur de microphone sont dopées dans des sens contraires au moins par parties de telle sorte qu'elles forment une diode en cas de contact et
**en ce que** la tension de charge appliquée entre l'électrode déformable (11) et l'électrode complémentaire (12) est polarisée de telle sorte que cette diode soit raccordée dans la direction de blocage.

2. Elément semiconducteur (10) selon la revendication 1, **caractérisé en ce que** la transition p-n de la diode est située entre les deux électrodes (11, 12) du condensateur de microphone.

3. Elément semiconducteur selon la revendication 1, **caractérisé en ce que** la transition p-n de la diode est située à l'intérieur de l'une des deux électrodes (42) du condensateur de microphone.

4. Elément semiconducteur selon l'une des revendications 1 à 3, **caractérisé en ce que** boutons de butée (23) sont formés sur l'électrode mobile et/ou sur l'électrode complémentaire (22).

5. Elément semiconducteur selon la revendication 4, **caractérisé en ce que** les deux électrodes (31, 32) du condensateur de microphone présentent un dopage de base de même nature et ce que les boutons de butée (33) ou les parties d'électrode situées face aux boutons de butée sont dopées dans des sens différents.

6. Elément semiconducteur selon la revendication 4, **caractérisé en ce que** les deux électrodes (41, 42) du condensateur de microphone présentent des dopages de base de sens opposés et ce que les boutons de butée (43) ou les parties d'électrode situées face aux boutons de butée ne sont pas dopés de manière à présenter le même dopage que l'électrode opposée (41).
